(19) Europäisches Patentamt
European Patent Office
Office européen des brevets

(11) **EP 2 096 765 A2**

(12) **EUROPEAN PATENT APPLICATION**

| | |
|---|---|
| (43) Date of publication:<br>**02.09.2009  Bulletin 2009/36** | (51) Int Cl.:<br>***H03M 13/39*** *(2006.01)*  ***H03M 13/45*** *(2006.01)* |

(21) Application number: **08166718.0**

(22) Date of filing: **15.10.2008**

| | |
|---|---|
| (84) Designated Contracting States:<br>**AT BE BG CH CY CZ DE DK EE ES FI FR GB GR HR HU IE IS IT LI LT LU LV MC MT NL NO PL PT RO SE SI SK TR**<br>Designated Extension States:<br>**AL BA MK RS** | (72) Inventor: **Piirainen, Olli**<br>**90100 Oulu (FI)**<br><br>(74) Representative: **Style, Kelda Camilla Karen**<br>**Page White & Farrer**<br>**Bedford House**<br>**John Street**<br>**London, WC1N  2BF (GB)** |
| (30) Priority:  **29.02.2008  GB 0803832** | |
| (71) Applicant: **Nokia Siemens Networks OY**<br>**02610 Espoo (FI)** | |

(54) **Max-Log MAP decision**

(57)    A technique comprising determining a first value associated with a received signal mapping the first value onto a second value calculating a soft decision for the received signal using the second value.

Figure 5

**Description**

**INTRODUCTION**

The present invention relates to a method and apparatus and in particular, but not exclusively to, a method and apparatus for generating a Max-log MAP decision for a received quadrature amplitude modulation signal.

**BACKGROUND TO THE INVENTION**

A communication device can be understood as a device provided with appropriate communication and control capabilities for enabling use thereof for communication with other parties. The communication may comprise, for example, communication via voice, electronic mail (email), text messages, data, multimedia and so on. A communication device particularly enables the user of the device to receive and transmit communications via a communication system and thus can be used for accessing various services and applications.

A communication system is a facility which facilitates communication between two or more entities such as the communication devices, network entities and other nodes. A communication system may be provided by one or more interconnected networks.

Communication between the communication devices, network entities and other nodes is typically performed by modulating a data stream on to a carrier frequency. The modulated data stream may then be transmitted via a wired or a wireless interface. Examples of wireless interfaces include Global System for Mobile communications (GSM), Third Generation Partnership Project Long Term Evolution (3GPP LTE), Universal Mobile Telecommunications System (UMTS), Enhanced Data rates for GSM Evolution (EDGE), High-Speed Packet Access (HSPA), High Speed OFDM Packet Access (HSOPA), Wideband Code Division Multiple Access (W-CDMA), WiMax. Examples of wired systems include Ethernet and fibre optic.

When data is encoded on to a carrier frequency the data is arranged in symbols. Each symbol represents a value. The most basic form that a symbol can take is a two value symbol representing a single bit. Recently, in order to increase data rates, more complicated symbols comprising more than two values have been used for data transmission. Typically, the number of vales which a symbol may take is a power of 2, i.e. 2, 4, 8, 16, representing 1, 2, 3 and 4 bits per symbol respectively.

To transmit these higher order symbols more complicated methods of encoding symbols onto a carrier wave have been used. Examples of these more complicated methods include, but are not limited to, amplitude shift keying and phase shift keying.

Amplitude shift keying is a method in which the amplitude of a signal is varied to represent different data. For example, a two bit symbol, representing four levels, may be modulated onto the carrier frequency by representing the symbol as four discrete levels of amplitude.

Phase shift keying is a method in which the phase of the carried signal is altered to represent different symbols. The phase of a signal may be altered by a number of discrete angles to represent different symbols. For example, for a two bit symbol (representing four levels) the phase of a transmitted signal my be shifted by angles of 0, $\pi/2$, $\pi$ and - $\pi/2$.

While amplitude shift keying and other simpler techniques only require a single carrier signal, phase shift keying requires a quadrature carrier. In other words, phase shift keying requires two carriers which are transmitted $\pi/2$ (90 degrees) out of phase.

Recently, even more complex systems have started to be used. These systems represent a combination of amplitude shift keying and phase shift keying. For example, two different amplitude levels and four different phase shifts may be combined to represent eight values, or a 3 bit symbol. An example of such a system is quadrature amplitude modulation or QAM.

The phase and/or amplitude shifts in the above systems may be represented as complex numbers.

A complex number is a number with a real and an imaginary part. A complex number $z$ may be represented in a Cartesian coordinate system as $z = x + i \cdot y$, where $i^2$ -1 and $x$ and $y$ are values representing the real and imaginary parts of $z$ respectively. In a polar coordinate system, the complex number $z$ may be represented by $z = Ae^{i\theta}$ where $A =$ $|z|$ (A equals the modulus or absolute value of $z$), and $\theta$ is the argument of $z$. It can be shown that $A = \sqrt{(x^2 + y^2)}$ and $\tan\theta = x/y$.

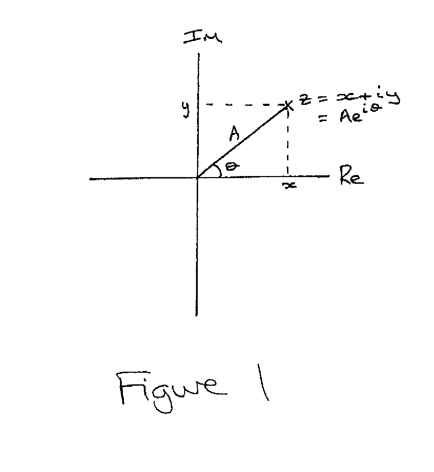

Since a complex number has two arguments, it may be represented as a point on a two dimensional plane. Such representation is often called an Argand diagram. As shown above, the complex number may be represented by a Cartesian or Euclidean coordinate $(x,y)$ or represented by a in polar coordinate $(A,\theta)$. Figure 1a shows such a diagram representing the complex number $z$ on an Argand diagram.

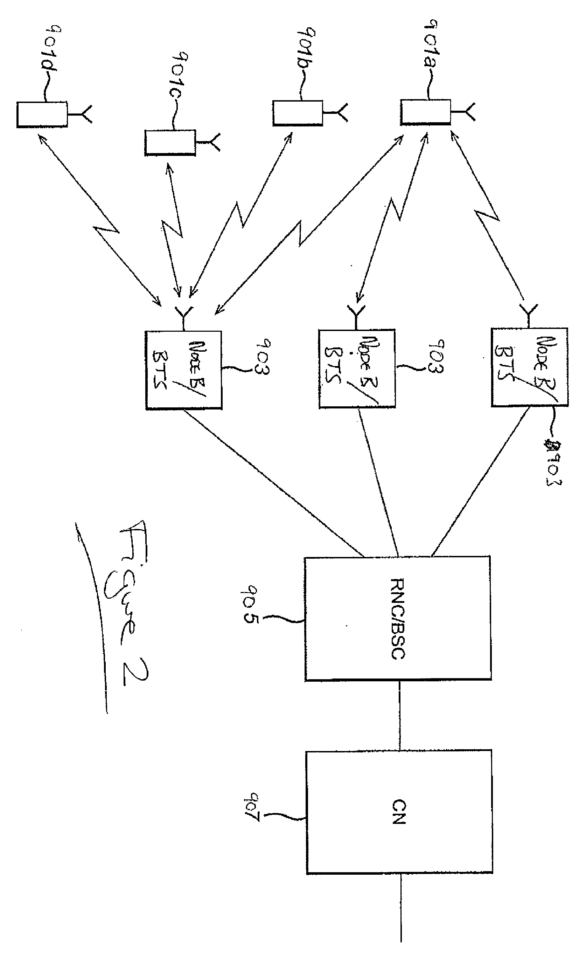

As mentioned above, the phase and/or amplitude shifts which represent a value of a symbol can be represented as a complex number. The complex number values which represent each possible symbol value may therefore be represented as points on an Argand diagram, forming what is typically described as a constellation diagram. One such constellation diagram is shown in Figure 2.

The constellation diagram shown in Figure 2 represents a typical quadrature amplitude modulation (QAM) scheme. As can be seen, the constellation points are arranged in a square grid with equal vertical and horizontal spacing between each point. Such a square scheme is typical, although other arrangements are possible. The scheme represented by Figure 2 is known as 16-QAM since there are 16 possible symbol values or points on the constellation diagram, each point capable of being uniquely defined by 4 bits. Other "square" or QAM schemes include 64-QAM and even 256-QAM, representing 64 points (6 bits) and 256 points (8 bits) respectively.

Non-square schemes may include, for example, circular 16-QAM, in which points are represented by one of two levels along one of eight equally spaced radii. Such schemes provide better performance over square schemes, but are harder to encode and decode.

A symbol representing a part of a data stream will be encoded onto a carrier wave by an encoder in a transmitter. The encoded signal will then be transmitted via an appropriate medium (discussed above), and received at a receiver. The receiver will decode the received signal and make a decision as to which value (or constellation point) the received symbol represents.

A transmitted signal will be affected by both noise, which is random, and by measurable effects such as "multipath" effects (i.e. signals reflected along different paths which are received at different times at the receiver). The measurable effects may be measured using training sequences and removed by an equalizer from a subsequently received signal.

For a transmitted signal X, the received signal can be represented by:

$$\mathbf{Y} = \mathbf{H} \cdot \mathbf{X} + \mathbf{N} \hspace{4cm} (1)$$

where **H** represents the measurable effects (often called the channel matrix) and **N** represents noise.

Due to the noise component, the received signal will not correlate exactly to a constellation point. The received symbol may be represented by its own point on a constellation diagram. The receiver will then attempt to match this received symbol to one of the constellation points.

The receiver may typically make a "soft decision" to assist in the decision of which constellation point corresponds to the received signal. A soft decision may be contrasted with a hard decision in that a hard decision assigns the received signal a definite symbol value, whereas a soft decision provides a candidate symbol value and an indication of the uncertainty of this value being that of the received signal. In other words, the soft decision provides an indication of the probability that that the data represented in the soft decision corresponds to the transmitted data.

The soft decision is of greater use in an error correcting algorithm. In particular the error correcting algorithms are able to use soft decision information to make an estimate of which bit in a received signal is an error.

Depending on the encoding method used, there may be a different levels of certainty associated with each bit of a symbol. The soft decision my therefore be calculated separately for each bit.

The soft information may be formed, for example, by using a log-MAP (logarithmic maximum *a prior*) generation process. This log-MAP generation process calculates the Log Likelihood Ratio (LLR) for a given bit as being representative of the soft decision for a given bit.

The LLR is the logarithm of the likelihood ratio. In the present case, where the value for a symbol or bit is being determined, the likelihood ratio is the ratio of the probability that the bit corresponds to a value of 1, against the probability that the bit corresponds to a value of 0.

To simplify notation, a received symbol will be represented by $z$, and the constellation points to which this symbol could correspond will be represented by $p$. The set of all constellation points will be represented by $P$, with $_np$ representing the $n$th symbol from this set. A series of bits are associated with each constellation point $p$ and with the received symbol $z$. For example, in a 16-QAM symbol, 4 bits are used to uniquely define each constellation point. The ith bit of a given constellation point is therefore represented by $p_i$. The soft decisions for each bit $i$ for the received symbol $z$ are represented by $b_i$.

The probability that $z$ corresponds to symbol $_np$ is given by

$$P(z=_np) = Ce^{\frac{-|z-_nP|^2}{\delta^2}} \tag{2}$$

where $\delta$ is a measure of the noise and $C$ is a constant.

The probability is a representation of the Euclidian distance between the received symbol $z$ and the given constellation point $p$.

The LLR is for a given bit $i$ of a received signal is given by

$$LLR_i = \ln\left(\frac{P(z_i = 1)}{P(z_i = 0)}\right) \tag{3}$$

Combining provides:

$$LLR_i = \ln\left(\frac{\sum_{\forall p \in P_i} e^{\frac{-|z-p|^2}{\delta^2}}}{\sum_{\forall p \in P_i} e^{\frac{-|z-p|^2}{\delta^2}}}\right) \tag{4}$$

Where $P_1$ is the group of all symbols $p$ for which the bit $p_i = 1$:

$$P_1 = \{p \in P : p_i = 1\} \tag{5}$$

similarly $P_0$ is the group of all symbols $p$ for which the bit $p_i = 0$:

$$P_0 = \{p \in P : p_i = 0\} \tag{6}$$

As can be seen, the probability that a particular bit in a symbol corresponds to a value based upon all probabilities throughout the constellation diagram. In other words the technique must calculate the probability that a given bit corresponds to a given value for each and every constellation point. When using high order quadrature amplitude modulation systems, such calculations quickly become too complex to be performed in real time.

To simplify the decoding, Max log-MAP metric is more typically used. The Max log-MAP metric corresponds only to the constellation points (one for each value of the bit $i$) representing the maximum probability. In other words, for a given bit $i$ of a received symbol, the decoder will compare the position of the received symbol with that of the closest constellation point for which the bit $i$ is 0 and the closest constellation point for which bit $i$ is 1.

The LLR is therefore:

$$\mathrm{LLR}_j = \ln\left(\frac{\displaystyle\max_{\forall p \in P_1} e^{\frac{-|z-p|^2}{\delta^2}}}{\displaystyle\max_{\forall p \in P_0} e^{\frac{-|z-p|^2}{\delta^2}}}\right) \qquad (7)$$

which may be simplified to:

$$\mathrm{LLR}_j = \left(\min_{\forall p \in P_0}|z-p|^2 - \min_{\forall p \in P_1}|z-p|^2\right)\cdot\delta^{-2} \qquad (8)$$

This value is easier to calculate. It will be seen from equation (8) that when the received symbol $z$ is closer to a point in $P_1$ than one in $P_0$, the LLR will be positive, similarly when the received symbol $z$ is closer to a point in $P_0$ than one in $P_1$, the LLR will be negative. Therefore it can be seen that the LLR represents not only a measure of the uncertainty of the determination, but a positive or negative value (corresponding to 1 and 0 respectively) representing the most probable value for the received symbol. In other words, $b_i$ (the soft decision for bit $i$ of the received signal) is equal to LLR$_i$.

Despite this simplification, the LLR is still complex to calculate for higher order modulations and higher data rates. In particular, the consideration of all of the constellation points to determine the points corresponding to the minimum values for $|z - p|^2$. Typically methods for solving this equation rely on approximations to further reduce the complexity of the system. However, using approximate solutions produces a loss in performance since errors are intrinsic when approximations are made.

The purpose of the present invention to provide improved technique for receiving a modulated signal and overcome or at least mitigate some of the above identified problems. In particular it is an object of embodiments of the present invention to provide a simplified method to calculate an exact Max log-MAP metric for received signal.

## STATEMENT OF INVENTION

According to a first aspect of the invention there is provided an apparatus comprising; a determiner configured to determine a first value associated with a received signal; a processor configured to calculate an exact Max-Log maximum a priori decision for the received signal using the first value.

Preferably the exact Max-Log maximum a priori decision comprises a soft decision for the received signal. Preferably the apparatus comprises a mapper configured to map the first value onto a second value, wherein the processor is configured to calculate the exact Max-Log maximum a priori decision for the received signal using the second value.

According to a first aspect of the invention there is provided an apparatus comprising; a determiner configured to determine a first value associated with a received signal; a mapper configured to map the first value onto a second value; a processor configured to calculate a soft decision for the received signal using the second value.

Preferably the soft decision is an exact Max-Log maximum a priori decision.

Preferably the soft decision comprises at least one of: an indicator of a probability that the received signal corresponds to one or more of a plurality of known signals; and an indicator of a most probable one of the plurality of known signals. More preferably each of the plurality of known signals is represented by a plurality of bits. In embodiments the apparatus comprises a selector configured to select one of the plurality of bits, wherein the processor is configured to calculate a soft decision for a selected one of the plurality of bits. In embodiments the selector is configured to select each of the plurality of bits and the processor is configured to calculate a soft decision for each selected bit.

Preferably the determiner is configured to determine the first value based on an identity of the selected bit.

Preferably the mapper is configured such that each possible value of the second value corresponds to two or more possible values of the first value. Preferably the mapper is configured to calculate an absolute value of the first value. More preferably the mapper is configured to add an offset to the calculated absolute value. More preferably the mapper is configured to perform one or more repeats of: calculating an absolute value of the first value and adding an offset to the calculated absolute value. More preferably the number of repeats is selected based on the selected bit.

Preferably the offset is selected based on the selected bit and the number of repeats which have been made.

Preferably the processor is configured to calculate a soft decision by solving the equation $b_i = (d\text{-}e)(2y\text{-}(d\text{+}e))\cdot\delta^{-2}$ where $b_i$ represents the soft decision for the selected bit, y represents the second value, $\delta^{-2}$ represents a function

of noise and $d$ and $e$ represent values dependent on the selected bit. More preferably at least one of $d$ and $e$ are dependent on a soft decision of a bit other that the selected bit.

Preferably the plurality of known signals correspond to points on a constellation diagram. More preferably the constellation diagram is a quadrature amplitude modulation constellation diagram. More preferably the constellation diagram comprises an axis, for each selected bit, wherein the axis is defined such that the axis passes through the centre of the constellation diagram, and the selected bit for each constellation point along a line parallel to the axes has the same value. More preferably the constellation diagram has a symmetry for a selected bit, the symmetry being determined by comparing a value of the selected bit for two or more constellation points aligned in a direction perpendicular to the axis.

Preferably the offset is determined based on the symmetry of the constellation diagram for the selected bit. Preferably the number of repeats is determined based on the symmetry of the constellation diagram for the selected bit. Preferably $d$ and $e$ are determined based on the symmetry of the constellation diagram for the selected bit.

Preferably the signal corresponds to a quadrature signal. More preferably the received signal is represented by a complex number. More preferably the complex number may be represented on a constellation diagram, the constellation diagram comprising a plurality of points corresponding to a plurality of known signals, wherein the processor is configured to calculate a soft decision based on the difference in Euclidian distance between the received signal when represented on the constellation diagram and a first and a second point on the constellation diagram, wherein the first point is the closest one of all of the points for which the selected bit has a value of 1 and the second point is the closest one of all of the points for which the selected bit has a value of 0.

Preferably the first value corresponds to the real or imaginary part of the complex number.

Preferably the apparatus comprises an equalizer configured to equalize the received signal.

According to a third aspect of the invention there is provided a method comprising; determining a first value associated with a received signal; calculating an exact Max-Log maximum a priori decision for the received signal using the first value.

Preferably the exact Max-Log maximum a priori decision comprises a soft decision for the received signal. Preferably the method comprises mapping the first value onto a second value, the calculating the exact Max-Log maximum a priori decision for the received signal using the second value.

According to a fourth aspect of the present invention there is provided a method comprising; determining a first value associated with a received signal; mapping the first value onto a second value; calculating a soft decision for the received signal using the second value.

Preferably the soft decision is an exact Max-Log maximum a priori decision.

Preferably the soft decision comprises at least one of: an indicator of a probability that the received signal corresponds to one or more of a plurality of known signals; and an indicator of a most probable one of the plurality of known signals. More preferably each of the plurality of known signals is represented by a plurality of bits. In embodiments the method comprises selecting one of the plurality of bits, wherein the calculating comprises calculating a soft decision for a selected one of the plurality of bits. In embodiments the method comprises selecting each of the plurality of bits and calculating a soft decision for each selected bit.

Preferably the determining comprises determining the first value based on an identity of the selected bit.

Preferably the mapping is configured such that each possible value of the second value corresponds to two or more possible values of the first value. Preferably the mapping comprises calculating an absolute value of the first value. More preferably the mapping comprises adding an offset to the calculated absolute value. More preferably the mapping comprises one or more repeats of: calculating an absolute value of the first value and adding an offset to the calculated absolute value. More preferably the number of repeats is selected based on the selected bit.

Preferably the offset is selected based on the selected bit and the number of repeats which have been made.

Preferably the calculating a soft decision comprises solving the equation $b_i = (d-e)(2y-(d+e) \cdot \delta^{-2}$ where $b_i$ represents the soft decision for the selected bit, $y$ represents the second value, $\delta^{-2}$ represents a function of noise and $d$ and $e$ represent values dependent on the selected bit. More preferably at least one of $d$ and $e$ are dependent on a soft decision of a bit other that the selected bit.

Preferably the plurality of known signals correspond to points on a constellation diagram. More preferably the constellation diagram is a quadrature amplitude modulation constellation diagram. More preferably the constellation diagram comprises an axis, for each selected bit, wherein the axis is defined such that the axis passes through the centre of the constellation diagram, and the selected bit for each constellation point along a line parallel to the axes has the same value. More preferably the constellation diagram has a symmetry for a selected bit, the symmetry being determined by comparing a value of the selected bit for two or more constellation points aligned in a direction perpendicular to the axis

Preferably the offset is determined based on the symmetry of the constellation diagram for the selected bit. Preferably the number of repeats is determined based on the symmetry of the constellation diagram for the selected bit. Preferably $d$ and $e$ are determined based on the symmetry of the constellation diagram for the selected bit.

Preferably the signal corresponds to a quadrature signal. More preferably the received signal is represented by a complex number. More preferably the complex number may be represented on a constellation diagram, the constellation diagram comprising a plurality of points corresponding to a plurality of known signals, wherein the soft decision is based on the difference in Euclidian distance between the received signal when represented on the constellation diagram and a first and a second point on the constellation diagram, wherein the first point is the closest one of all of the points for which the selected bit has a value of 1 and the second point is the closest one of all of the points for which the selected bit has a value of 0.

Preferably the first value corresponds to the real or imaginary part of the complex number.

Preferably the method comprises equalizing the received signal.

According to a fifth aspect of the invention there is provided a computer program product comprising a method comprising; determining a first value associated with a received signal; calculating an exact Max-Log maximum a priori decision for the received signal using the first value.

Preferably the exact Max-Log maximum a priori decision comprises a soft decision for the received signal. Preferably the computer program product comprises a method comprising mapping the first value onto a second value, the calculating the exact Max-Log maximum a priori decision for the received signal using the second value.

According to a sixth aspect of the invention there is provided a computer program product comprising a method comprising; determining a first value associated with a received signal; mapping the first value onto a second value; calculating a soft decision for the received signal using the second value.

Preferably the soft decision is an exact Max-Log maximum a priori decision.

Preferably the soft decision comprises at least one of: an indicator of a probability that the received signal corresponds to one or more of a plurality of known signals; and an indicator of a most probable one of the plurality of known signals. More preferably each of the plurality of known signals is represented by a plurality of bits. In embodiments the computer program product comprises a method comprising selecting one of the plurality of bits, wherein the calculating comprises calculating a soft decision for a selected one of the plurality of bits. In embodiments the computer program product comprises a method comprising selecting each of the plurality of bits and calculating a soft decision for each selected bit.

Preferably the determining comprises determining the first value based on an identity of the selected bit.

Preferably the mapping is configured such that each possible value of the second value corresponds to two or more possible values of the first value. Preferably the mapping comprises calculating an absolute value of the first value. More preferably the mapping comprises adding an offset to the calculated absolute value. More preferably the mapping comprises one or more repeats of: calculating an absolute value of the first value and adding an offset to the calculated absolute value. More preferably the number of repeats is selected based on the selected bit.

Preferably the offset is selected based on the selected bit and the number of repeats which have been made.

Preferably the calculating a soft decision comprises solving the equation $b_i = (d-e)(2y-(d+e)) \cdot \delta^{-2}$ where $b_i$ represents the soft decision for the selected bit, $y$ represents the second value, $\delta^{-2}$ represents a function of noise and $d$ and $e$ represent values dependent on the selected bit. More preferably at least one of $d$ and $e$ are dependent on a soft decision of a bit other that the selected bit.

Preferably the plurality of known signals correspond to points on a constellation diagram. More preferably the constellation diagram is a quadrature amplitude modulation constellation diagram. More preferably the constellation diagram comprises an axis, for each selected bit, wherein the axis is defined such that the axis passes through the centre of the constellation diagram, and the selected bit for each constellation point along a line parallel to the axes has the same value. More preferably the constellation diagram has a symmetry for a selected bit, the symmetry being determined by comparing a value of the selected bit for two or more constellation points aligned in a direction perpendicular to the axis

Preferably the offset is determined based on the symmetry of the constellation diagram for the selected bit. Preferably the number of repeats is determined based on the symmetry of the constellation diagram for the selected bit. Preferably $d$ and $e$ are determined based on the symmetry of the constellation diagram for the selected bit.

Preferably the signal corresponds to a quadrature signal. Preferably the received signal is represented by a complex number. Preferably the complex number may be represented on a constellation diagram, the constellation diagram comprising a plurality of points corresponding to a plurality of known signals, wherein the soft decision is based on the difference in Euclidian distance between the received signal when represented on the constellation diagram and a first and a second point on the constellation diagram, wherein the first point is the closest one of all of the points for which the selected bit has a value of 1 and the second point is the closest one of all of the points for which the selected bit has a value of 0.

Preferably the first value corresponds to the real or imaginary part of the complex number.

Preferably the computer program product comprises a method comprising equalizing the received signal.

According to a seventh aspect of the invention there is provided an apparatus comprising; means for determining a first value associated with a received signal; means for calculating an exact Max-Log maximum a priori decision for the received signal using the first value.

According to a eighth aspect of the invention there is provided an apparatus comprising; means for determining a first value associated with a received signal; means for mapping the first value onto a second value; means for calculating a soft decision for the received signal using the second value.

**SUMMARY OF FIGURES**

For a better understanding of the present invention and as to how the same may be carried into effect, reference will now be made by way of example only to the accompanying drawings, in which:

Figure 1 shows an Argand diagram for complex value $z$;
Figure 2 shows a schematic view of a communications system within which embodiments of the invention may be employed;
Figure 3 shows a schematic view of a possible electronic device within which embodiments of the invention may be employed;
Figure 4 shows a constellation diagram for a 16-QAM system;
Figure 5 shows four constellation diagrams each showing only one of the bits from the constellation diagram in Figure 4;
Figure 6 shows the constellation diagram for calculating a $b_3$ in a 16-QAM system;
Figures 7a and 7b visualize a mapping operation for a bit $b_3$;
Figures 8a and 8b visualize mapping operation for a bit $b_1$;
Figure 9 shows a constellation diagram for a 64-QAM system;
Figures 10a, 10b and 10c visualize a mapping operation for a bit $b_5$;
Figures 11a, 11b and 11c visualize a mapping operation for a bit $b_3$;
Figures 12a and 12b visualize a mapping operation for a bit $b_1$;
Figure 13 shows a method according to an embodiment of the invention; and
Figure 14 shows a detailed schematic view of part of the electronic device shown in Figure 3.

**DESCRIPTION**

The invention will now be further described by way of example only, with reference to the following specific embodiments.

Figure 2 shows a schematic view of a communications system within which the embodiments of the present invention can be implemented. The system comprises at least one user equipment (UE) 901. User equipment 901 can be for example a mobile telephone, but could also be for example a communication capable laptop, personal digital assistant, or any other suitable device.

User equipment 901 communicates wirelessly by radio with a series of radio base station transceivers (BTS) 903. The radio base stations are also known in the UMTS standard as Node-B. In the following description the terms Node-B and base station transceivers (BTS) are to be used interchangeably.

Each user equipment 901 is arranged to be able to communicate to more than one BTS 903 and similarly each BTS 903 is arranged to be capable of communicating to more than one UE 901. The BTS 903 further communicates with a radio network controller (RNC) 905 (which is also known in the GSM standard as a Base station controller (BSC)). The RNC 905 can further communicate to a core network (CN) 907. The CN 907 can further communicate with other networks, for example further public land mobile networks (PLMNs) or to the network of computers known as the 'Internet'.

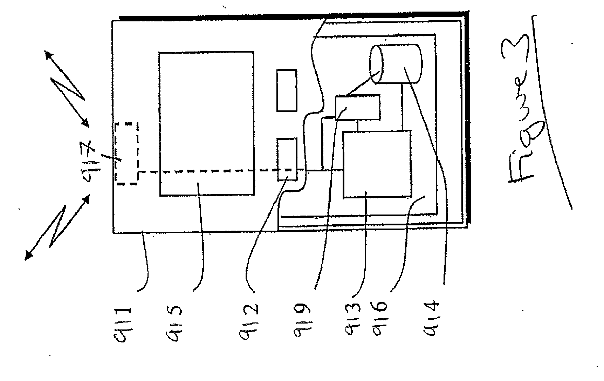

Figure 3 shows a schematic partially sectioned view of a possible electronic device capable of implementing embodiments of the invention. The electronic device may be a user equipment as shown in Figure 2, alternatively or additionally, the electronic device may be the Node B as shown in Figure 2.

Although an electronic device is shown in the form of user equipment embodiments of the invention may be implemented in any electronic device requiring a decoder. An appropriate electronic device may be any device capable of receiving signals via a wired and/or wireless interface. Non-limiting examples include mobile stations (MS), user equipment (UE), base stations (BS), WiFi (IEEE 802.11) receivers, portable computer equipment, personal data assistants (PDA), network routers, network nodes, gateways, communications hubs or any combinations of these or the like.

The electronic device may communicate via an appropriate wired or wireless interface arrangement 917. The interface arrangement may be provided by means of a radio frequency and associated antenna arrangement. Alternatively or additionally, the interface may be provided by means of a wired network controller such as an Ethernet controller.

The electronic device is typically provided with at least one data processor 913 and at least one memory 914 for storing data and instructions used by the data processor 913. In addition, dedicated hardware, such as a hardware decoder 919 may be provided. The data processor 913, memory 914 and dedicated hardware 919 may be provided on an appropriate circuit board and/or in chip sets 916.

In some embodiments, when the electronic equipment is a user equipment, the user may control the operation of the electronic device by means of a suitable user interface such as a keypad 912, voice command, touch-sensitive screen or pad, or a combination thereof or the like. A display 915, a speaker and/or a microphone may also be provided. Furthermore, an electronic device may comprise appropriate connectors (either wired or wireless) to other electronic devices and/or for connecting external accessories, for example hands-free equipment, thereto.

Alternatively or additionally, the electronic device may be capable of being controlled by remote operation, and as such the user interface capabilities may be optional.

In operation, the electronic device may operate to send and receive signals via interface arrangement 917. The signals may be encoded by using any one or a plurality encoding techniques. In particular, the signals may be encoded using a quadrature amplitude modulation technique such as 16-QAM, 64-QAM or 256-QAM, although other techniques are possible.

An encoded signal is received by the interface arrangement 917 and passed to processor 913 and/or to dedicated hardware 919. The received signal may alternatively or additionally be stored in the memory 914.

The interface arrangement 917, processor 913, memory 914 and/or dedicated hardware 919 may serve alone or in combination to decode the received signal. This decoding may include: downconverting the received signal from a carrier frequency; converting the signal from an analogue signal to a digital signal; analyzing the signal; equalizing the signal; filtering the signal; and removing channel effects such as intersymbol interference from the signal.

In some embodiments a known training sequence will be transmitted to be received at the receiver. Since this sequence is known it may be used to determine parameters of the connection between the transmitter and the receiver. In other words an estimation of the systematic connection characteristics (**H**) may be made. The determined parameters may be stored in the memory 914.

In addition, the decoding will include providing soft decisions for the received signal. A soft decision, as described above, contains both an indication of the data content of the received signal and an indication of the uncertainty that the data content is correct. These soft decisions are used in error correcting algorithms to correct for errors in the received signal. One such error correcting algorithm which may be used is a turbo code.

This decoded signal may subsequently be retransmitted by the interface 917 or by a further interface. The decoded signal may be stored in the memory 914, or used in a calculation in processor 913. The decoded signal may be used to drive the display 915 or a speaker or other interface attached to the electronic device.

In generating the soft decision, the processor 913, dedicated hardware 919, interface 917 or any other hardware which may by used, may generate a Max log-MAP decision for the received signal. To understand the technique, it can be visualized using the constellation diagrams as described above.

The received symbol, when represented on a constellation diagram, represents a modified signal for which, at least, the amplitude of the symbol has been scaled to allow comparison with the constellation points. In other words, the constellation diagrams have an arbitrary scaling defined by constant $s$, the received signal will be therefore modified to be in conformity with the scaling of the constellation diagram. This may be performed by an equalizer.

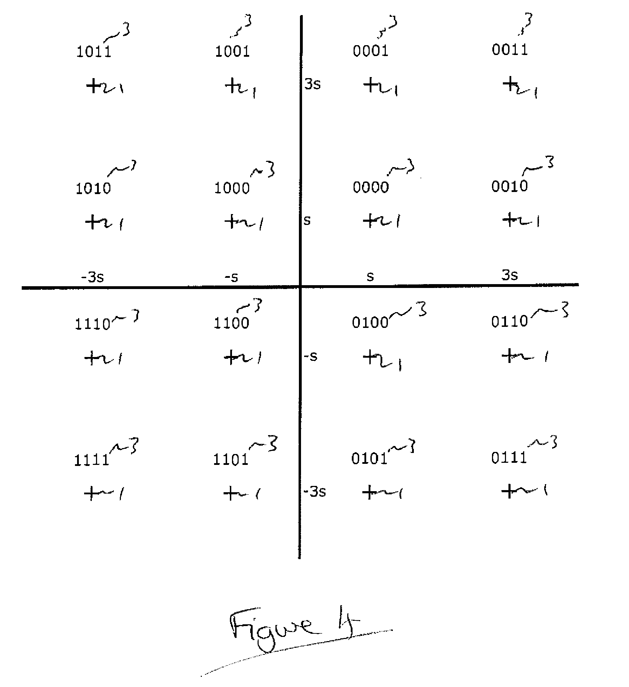

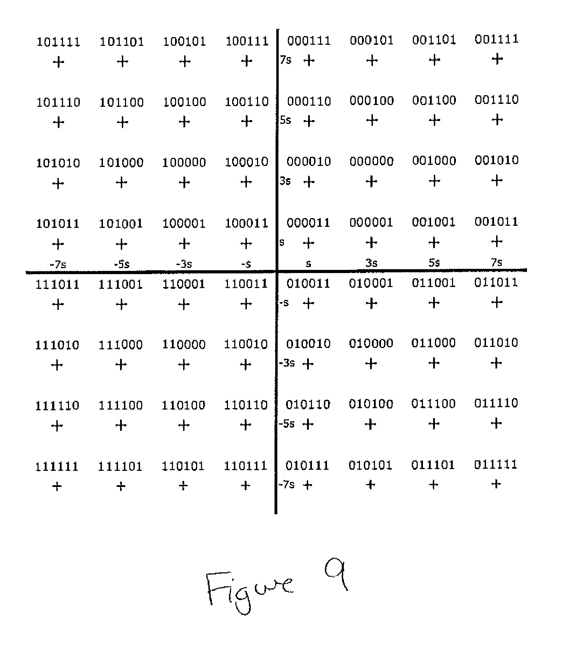

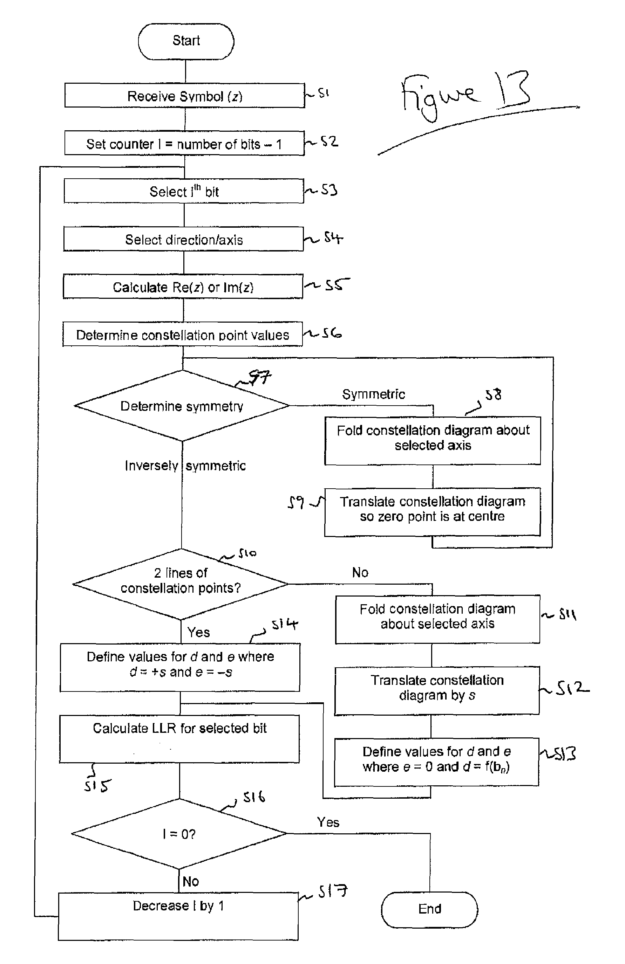

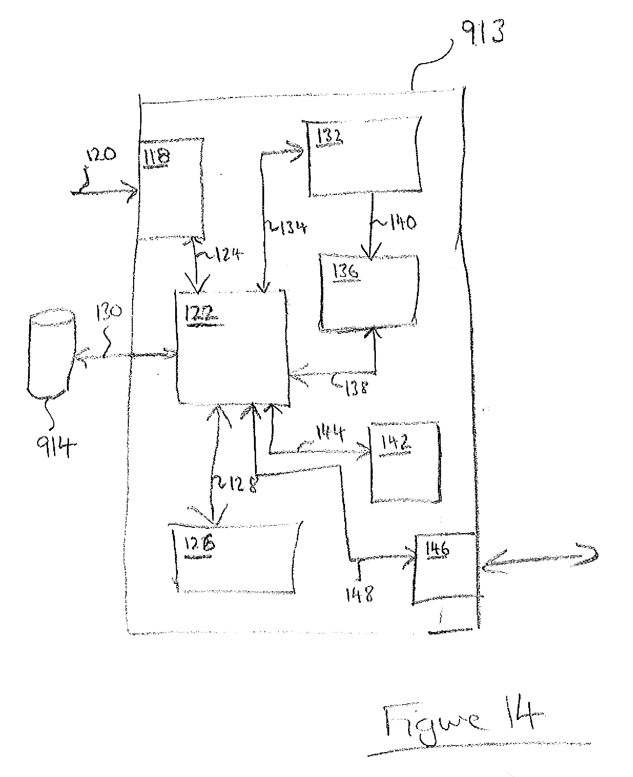

Techniques according to embodiments of the invention will now be described with reference to Figures 4 to 14 below. An embodiment of the invention applicable to a 16-QAM system will be described with the assistance of Figures 4 to 8b. A further embodiment of the invention applicable to a 64-QAM system will be described with the assistance of Figures 9 to 12b. Finally, with the assistance of Figures 13 and 14, a practical technique embodying the invention when applied to a more generalized system will be described.

Figure 4 shows a typical constellation diagram for a 16-QAM (quadrature amplitude modulation) system. Each constellation point 1 is marked with a "+" sign. The four digit binary number 3 above the constellation point marks the binary value associated with that constellation point 1.

The assignment of binary vales 3 to the constellation points 1 is ordered according to a Gray coding. This means that each adjacent constellation point 1 differs from its neighbours by only one bit. Using Gray coding provides greater symmetry to the system.

The axes are marked with a scale marked by multiples of a constant $s$. The distance between consecutive constellation points is $2s$, consequently the constellation points are located at odd multiples of $s$ from the axes. The value of $s$ is dependent on the system used and is typically chosen such that the average power of all the constellation points is 1. The power associated with a particular constellation point is the square of the Euclidian distance of the point from the origin. In a 16-QAM system, 4 points have a power of $18s^2$, 8 have a power of $10s^2$ and 4 have a power of $2s^2$. Consequently the average power for each constellation point is equal to $10s^2$, and therefore in order for the average power of all the constellation points to be unity we may choose $s = 1/\sqrt{10}$.

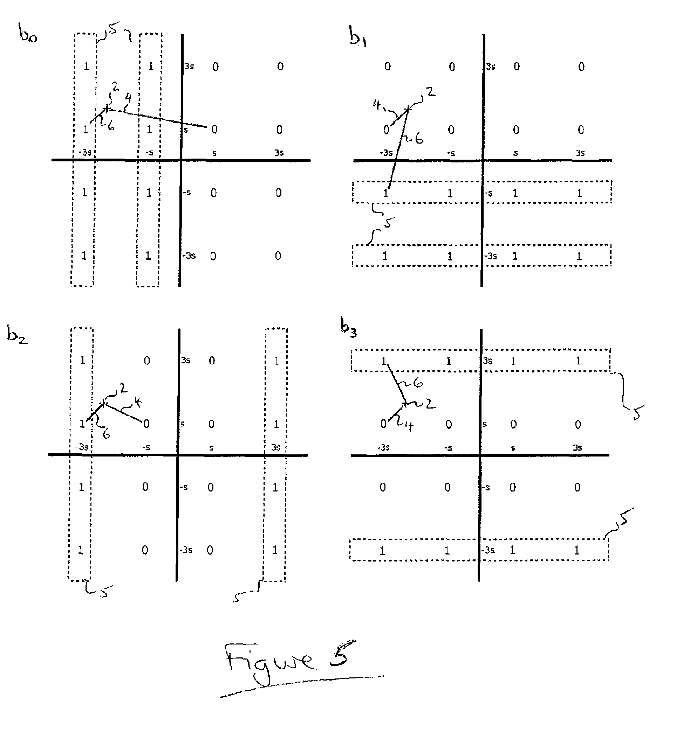

Figure 5 shows four constellation diagrams each showing the location or grouping of symbol values having specific bit values for only one of the bits from the constellation diagram in Figure 4. The diagrams are labelled $b_0$ to $b_3$

signifying the bit referred to. Each constellation point is marked by its value for the corresponding bit. In other words, the graph labelled b$_3$ shows which constellation points have which values for $p_3$ - the third binary value.

Each of the constellation diagrams show that the constellation points have bit values which are repeated in either the horizontal or vertical directions. In Figure 5, the groups of constellation points in which the particular bit has a value of 1 are marked with a dotted line 5.

The example scaled received symbol 2 is also shown in Figure 5, marked as a "+". In addition lines 4 and 6 are shown marking the shortest distance from the received symbol 2 to a constellation point containing a particular binary value (0 and 1 respectively).

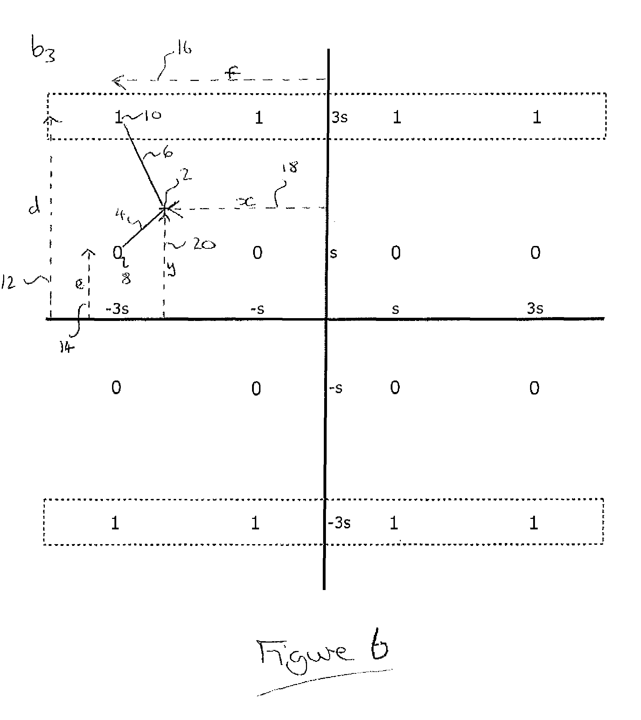

A method according to an embodiment of the invention will now be described with reference to Figures 6, 7a, 7b, 8a, and 8b.

Figure 6 shows the constellation diagram for calculating b$_3$. Each constellation point is marked by the value of the third bit for that constellation point, i.e. the value of $p_3$. Received symbol 2 is shown with lines 4 and 6 marking the distance from the received symbol 2 to constellation points 8 and 10. Constellation point 8 is the closest constellation point to the received symbol for which the third bit has a value of 0.

Constellation point 10 is the closest constellation point to the received symbol for which the third bit has a value of 1.

In addition, the distances between the axis and the constellation points and receive symbol are shown as dotted lines 12, 14, 16, 18 and 20. Line 12, of length $d$, marks the distance between the real axis and the closest constellation point for which the third bit has a value 1 (reference number 10). Line 14, of length $e$, marks the distance between the real axis and the closest constellation point for which the third bit has a value 0 (reference number 8). Line 16, of length $f$, marks the distance between the imaginary axis and both of the two closest constellation points (8 and 10). Line 18, of length x, marks the distance between the received symbol 2 and the imaginary axis. Finally, line 20, of length y, marks the distance between the real axis and the received symbol 2.

It can therefore be seen that the received symbol 2 has coordinates $(x, y)$; the constellation point 8 has coordinates of $(f, d)$ and the constellation point 10 has coordinates of $(f, e)$.

The following shows a derivation of the log likelihood ratio for b$_3$ using this information.

The formula from above is:

$$\text{LLR}_i = \left( \min_{\forall p \in \mathcal{P}_0} |z - p|^2 - \min_{\forall p \in \mathcal{P}_1} |z - p|^2 \right) \cdot \delta^{-2} \qquad \text{(8 repeated)}$$

which can be re-written for the present case as:

$$\text{LLR}_3 = \left( |z - {}_0 p|^2 - |z - {}_1 p|^2 \right) \cdot \delta^{-2} \qquad (9)$$

where ${}_0 p$ represents constellation point 8 (which the closest constellation point for which the third bit of $p$, i.e. $p_3$, = 0). ${}_1 p$ represents constellation point 10 (which the closest constellation point for which the third bit of $p$, i.e. $p_3$, = 1). Substituting with $d, e, f, x$ and $y$:

$$\text{LLR}_3 = \left( \left( (f - x)^2 + (y - e)^2 \right) - \left( (f - x)^2 + (d - y)^2 \right) \right) \cdot \delta^{-2} \qquad (10)$$

which simplifies to:

$$\text{LLR}_3 = (d - e)(2y - (d + e)) \cdot \delta^{-2} \qquad (11)$$

As can be seen, neither x nor $f$ are present in the final result. This is due to the points being on the same line perpendicular to the real axis.

While the above equations represent a calculation calculated with respect to $b_3$ it will be apparent that it is applicable to the other values corresponding to the other bits ($b_2$, $b_1$, $b_0$). The equation for $b_1$ will be the same (as both nearest constellation points are the same distance from the imaginary axis), where $d$ and $e$ mark the distances between the real axis and the closest constellation points with values 1 and 0 respectively.

For bits $b_2$ and $b_0$ the equation for the LLR can be derived by analogy and by observing that the distances are measured parallel to the real axis rather than parallel to the imaginary axis. Therefore the LLR for bit $b_2$ is given by:

$$\mathrm{LLR}_2 = (d - e)(2x - (d + e)) \cdot \delta^{-2} \qquad (12)$$

where $d$ and $e$ mark the distances between the imaginary axis and the closest constellation points with values 1 and 0 respectively. The formula for the LLR for bit $b_0$ is the same as that for bit $b_2$ for the same reasons as above.

An alternative method of considering the relation between the calculation of the LLR for bits $b_2$ and $b_0$ is to observe that the arrangement of constellation points for which the second bit is 1 (i.e. $p_2 = 1$) is a reflection of the bits for which the third bit is 1 (i.e. $p_3 = 1$) through a line running through the origin from bottom left to top right, angled at 45 degrees to both the imaginary and real axes. Similarly the arrangement of constellation points for which the zero bit is 1 (i.e. $p_0 = 1$) is a reflection of the bits for which the first bit is 1 (i.e. $p_1 = 1$) through the same line.

The above calculation has been made in the unrealistic situation in which the relevant constellation points 8 and 10 had been identified. Accordingly, the other points could be ignored when making the calculation. In practice, the process by which the closest points are identified is non-trivial and requires consideration of all the points present in the constellation diagram.

A method embodying the invention, by which the LLR may be determined without the prior identification of the closest constellation points will now be described below with reference to the Figures.

In this embodiment, the first soft bit to be calculated is bit $b_3$. At a first stage in this calculation the constellation diagram is simplified by folding the constellation diagram about the real axis.

This folding operation may alternatively be considered as a mapping of all of the constellation points in the lower half of the constellation diagram based on the absolute value of the coordinate in the vertical (imaginary) direction. Alongside this mapping of constellation points the coordinates of any received symbol will also be mapped in to the top half of the constellation diagram.

The constellation diagram is then translated by a distance of $2s$ in the negative direction parallel to the imaginary axis. This may alternatively be considered as a translation of the zero point of the imaginary axis (which corresponds to the location of the real axis) a distance of $2s$ in the positive direction from the original axis.

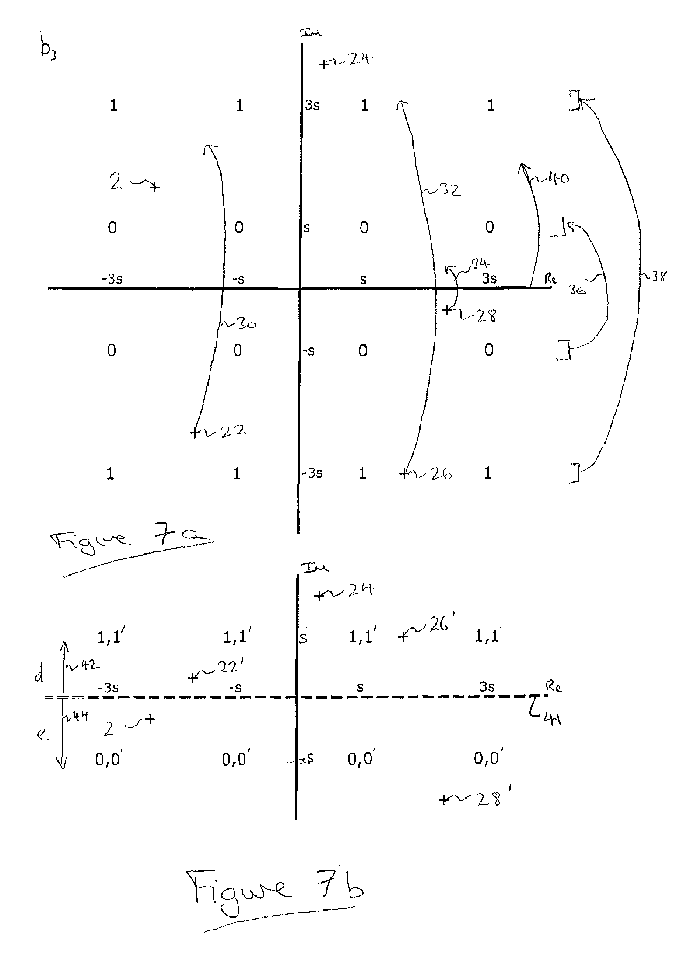

Figures 7a and 7b shows this mapping process in detail. For a better understanding of the process, a number of additional received symbol values have been shown, referenced by numerals 22, 24, 26 and 28. Arrows 32, 33 and 34 show the mapping of the received symbols 22, 26 and 28 respectively. Received symbols 22, 26 and 28 are mapped because they are in the lower half of the constellation diagram. Received symbols 2 and 24 are not mapped because they are in the upper half of the constellation diagram.

The mapping of the received symbols also correspond to a mapping of the constellation points. Arrows 36 and 38 show the mapping of the constellation points from the lower half (corresponding to negative values) to the upper half (corresponding to positive values).

Finally the constellation diagram is translated by $2s$ in the negative direction parallel to the imaginary axis. As mentioned above, this may be considered as a translation of the zero point of the imaginary axis. For simplicity, this translation is shown as a movement of the axis, and is represented by arrow 40.

The resultant constellation diagram is shown in Figure 7b. In this figure, received symbol points 2 and 24 remain unchanged, however received symbol points 22', 26' and 28' represent the mapped or folded points 22, 26 and 28. The new real axis is represented by the dotted line 41.

There will now be noted that the closest constellation points for each received symbol are now located along lines of value $s$ and $-s$. Each new constellation point now corresponds to a constellation point from both of the top and bottom halves of the original constellation diagram. These constellation points are shown by 0 and 1 for the unmapped points and 0' and 1' for the mapped points.

It can now be seen that for each received symbol the nearest constellation point for which the third bit has value 1 (i.e. $p_3 = 1$) is located along a line which crosses the imaginary axis at $s$ and is parallel to the real axis. Similarly, for each received symbol the nearest constellation point for which the third bit has value 0 (i.e. $p_3 = 0$) is located along a line which crosses the imaginary axis at $-s$ and is parallel to the real axis.

With reference back to Figure 4, it can now be seen that, irrespective of which constellation points are the closest to a received value, the values of $d$ and $e$ are always going to be $s$ and $-s$. Lines 42 and 44 show lengths $d$ and *e* respectively.

It can also be seen that the relative position of the received symbols relative to the constellation points is unchanged. Consequently, equation (11) may be used to directly and exactly calculate the LLR and thus b$_3$ without any further manipulation.

Mathematically, the calculation of the LLR for b$_3$ may be represented by the following, where *z* is the received symbol.

Set *s* as the 1 over the square root of 10:

$$s = \frac{1}{\sqrt{10}} \qquad (13)$$

Define y as the imaginary part of z:

$$y = \text{Im}(z) \qquad (14)$$

Fold (or map) the constellation diagram and scale the axis. Since the folding/mapping is specific to bit b$_3$, the newly defined value is labelled $y_3$:

$$y_3 = |y| - 2s \qquad (15)$$

As described above, as a result of the mapping, *d* = *s* and *e* = -*s*, therefore substitute these values into the equation for the LLR:

$$\text{LLR}_3 = 2s(2y_3 - 0) \cdot \delta^{-2} \qquad (16)$$

Therefore b$_3$, representing the soft decision for the third bit of received symbol *z* is:

$$b_3 = \text{LLR}_3 = 4sy_3 \cdot \delta^{-2} \qquad (17)$$

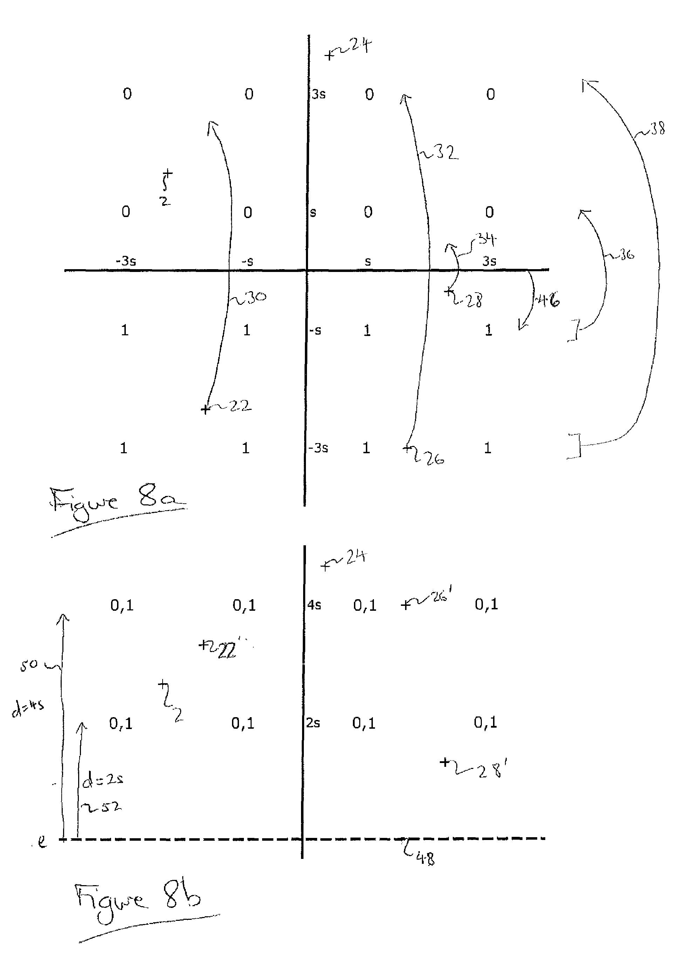

The calculation for b$_1$ will now be described with reference to Figures 8a and 8b.

Figure 8a shows the constellation diagram showing the constellation points marked by the value of the first bit, i.e. the constellation points labelled by the value of $p_1$. As with Figures 7a and 7b, additional received signal symbols 22, 24, 26 and 28 are shown.

By looking at Figure 8a it can be seen that the relevant constellation points used to calculate the LLR are located on opposite sides of the axis. Consequently, the sign of the bit b$_1$ corresponds to the sign of the imaginary part of value of the received symbol z, i.e. sgn(b$_1$) = sgn( Im(*z*)).

The full calculation of the LLR for b$_1$ is not so simply defined. Nevertheless, a mapping or folding operation may be used to again facilitate the calculation.

At a first stage in the calculation for b$_1$ the constellation diagram is simplified by folding the constellation diagram about the real axis. Again, this folding operation may alternatively be considered as a mapping of all of the constellation points in the lower half of the constellation diagram based on the absolute value of the coordinate in the vertical (imaginary) direction. Alongside this mapping of constellation points the coordinates of any received symbol will also be mapped in to the top half of the constellation diagram.

The constellation diagram is then translated by a distance of *s* in the positive direction parallel to the imaginary axis. This may alternatively be considered as a translation of the zero point of the imaginary axis (corresponding to the location of the real axis) a distance of $s$ in the negative direction from the original axis.

Figure 8a shows these mapping operations. Arrows 30, 32 and 34 show the mapping of the received symbols 22, 26 and 28. It is again noted that received symbols 2 and 24 do not need to be mapped. Arrows 36 and 38 show the mapping of the constellation points. Finally arrow 46 shows the mapping of the real axis, or zero point of the imaginary axis, downwards by one unit of $s$.

The resultant constellation diagram is shown is Figure 8b. Reference numbers 22', 26' and 28' show the mapped signal points 22, 26 and 28 respectively. The dotted line 48 shows the new axis as moved by arrow 46.

It can be seen that, for a received symbol in one half of the constellation diagram, one of the two nearest constellation points will be located in the other half of the diagram. In other words, for received symbol 2, located in the top half of the diagram, the nearest constellation point for which the first bit is 1 is in the bottom half of the diagram.

It can further be seen that the constellation point in the other half of the diagram will always be located along the line parallel to the real axis and at a distance of $s$ from this real axis.

The mapping or folding process described above has therefore placed the real axis on the line at which the constellation point on the other side of the axis was locate. Importantly, this is true for all of the received symbols irrespective of whether they were located in the top half or in the bottom half of the diagram.

Therefore, with reference to the equation for the LLR the value for e is zero, irrespective of the position of the received symbol.

The value of $d$ however will depend on the position of the received symbol. It can be seen that the value for $d$ will be either $4s$ (represented by line 50) or $2s$ (represented by line 52).

Advantageously, the selection of which value $d$ will take can be made by looking at the sign of the previously calculated bit $b_3$. If the received symbol is located closer to the constellation points arranged along a line parallel to, and at a distance $4s$ from, the real axis, then $b_3$ will reflect this by representing a value of 1. Given that $b_3$ is a soft decision, this means that the sign of $b_3$ will be positive (i.e. $\text{sgn}(b_3) = 1$).

If the converse is true, and the received symbol is located closer to the constellation points arranged along a line parallel to, and at a distance $2s$ from, the real axis, then $b_3$ will reflect this by representing a value of 0. This means that the sign of $b_3$ will be negative (i.e. $\text{sgn}(b_3) = -1$). $d$ may therefore be defined as:

$$d = \left(3 + \text{sgn}(b_3)\right)s \qquad (18)$$

Mathematically, this calculation of the LLR for $b_1$ may be represented by the following, where $z$ is the received symbol. Set $s$ as the 1 over the square root of 10:

$$s = \frac{1}{\sqrt{10}} \qquad (13 \text{ repeated})$$

Define y as the imaginary part of z:

$$y = \text{Im}(z) \qquad (14 \text{ repeated})$$

Fold (or map) the constellation diagram and scale the axis. Since the folding/mapping is specific to bit $b_1$, the newly defined value is labelled $y_1$:

$$y_1 = |y| + s \qquad (19)$$

Define $d$ and $e$:

$$d = \left(3 + \text{sgn}(b_3)\right)s, e = 0 \qquad (20)$$

Substitute these values into the equation for the LLR:

$$LLR_1 = -\text{sgn}(y)(d)(2y_1 - d) \qquad (21)$$

Therefore $b_1$, representing the soft decision for the first bit of received symbol $z$ is:

$$b_1 = LLR_1 = -\text{sgn}(y)(3 + \text{sgn}(b_3))s(2y_1 - (3 + \text{sgn}(b_3))s) \qquad (22)$$

The above method for determining the value for $b_3$ and $b_1$ may be used by analogy for $b_2$ and $b_0$. As noted above, the differences between $b_3$ and $b_1$ and $b_2$ and $b_0$ may be summarized as a reflection of the points in a diagonal line.

Consequently, the method for calculating $b_2$ and $b_0$ below will be summarized mathematically, but additional figures will not be provided.

For $b_2$:

Set $s$ as the 1 over the square root of 10:

$$s = \frac{1}{\sqrt{10}} \qquad \text{(13 repeated)}$$

Define x as the real part of z:

$$x = \text{Re}(z) \qquad (23)$$

Fold (or map) the constellation diagram and scale the axis. Since the folding/mapping is specific to bit $b_2$, the newly defined value is labelled $x_2$:

$$x_2 = |x| - 2s \qquad (24)$$

As described above, as a result of the mapping, $d$ = s and $e$ = -s, therefore substitute these values into the equation for the LLR:

$$LLR_2 = 2s(2x_2 - 0) \cdot \delta^{-2} \qquad (25)$$

Therefore $b_2$, representing the soft decision for the second bit of received symbol z is:

$$b_2 = LLR_2 = 4sx_2 \cdot \delta^{-2} \qquad (26)$$

For $b_0$: Set $s$ as the 1 over the square root of 10:

$$s = \frac{1}{\sqrt{10}} \qquad \text{(13 repeated)}$$

Define *x* as the real part of *z*:

$$x = \mathrm{Re}(z) \qquad\qquad (23\ \text{repeated})$$

Fold (or map) the constellation diagram and scale the axis. Since the folding/mapping is specific to bit $b_0$, the newly defined value is labelled $x_0$:

$$x_0 = |x| + s \qquad\qquad (19)$$

Define *d* and *e*:

$$d = (3 + \mathrm{sgn}(b_2))s, e = 0 \qquad\qquad (20)$$

Substitute these values into the equation for the LLR:

$$LLR_0 = -\mathrm{sgn}(x)(d)(2x_0 - d) \qquad\qquad (21)$$

Therefore $b_0$, representing the soft decision for the zero bit of received symbol *z* is:

$$b_0 = LLR_0 = -\mathrm{sgn}(x)(3 + \mathrm{sgn}(b_2))s(2x_0 - (3 + \mathrm{sgn}(b_2))s) \qquad (22)$$

The invention is not just applicable to 16-QAM as shown above, but to a large number of encoding schemes. A method according to a further embodiments of the invention will now be described with regards to 64-QAM.

Figure 9 shows a constellation diagram for a 64-QAM signal. each point is marked with a 6 digit binary number representing the data associated with the symbol. Again, a constant multiplier *s* is used to define the scaling of the axes. It can be seen that, like the 16-QAM constellation diagram, there is symmetry in the arrangement of the constellation points corresponding to a certain value of one of the bits.

Since each constellation point is marked by a six bit value, there will correspondingly be six soft decisions made for the received symbol. These will be marked $b_0$ to $b_5$.

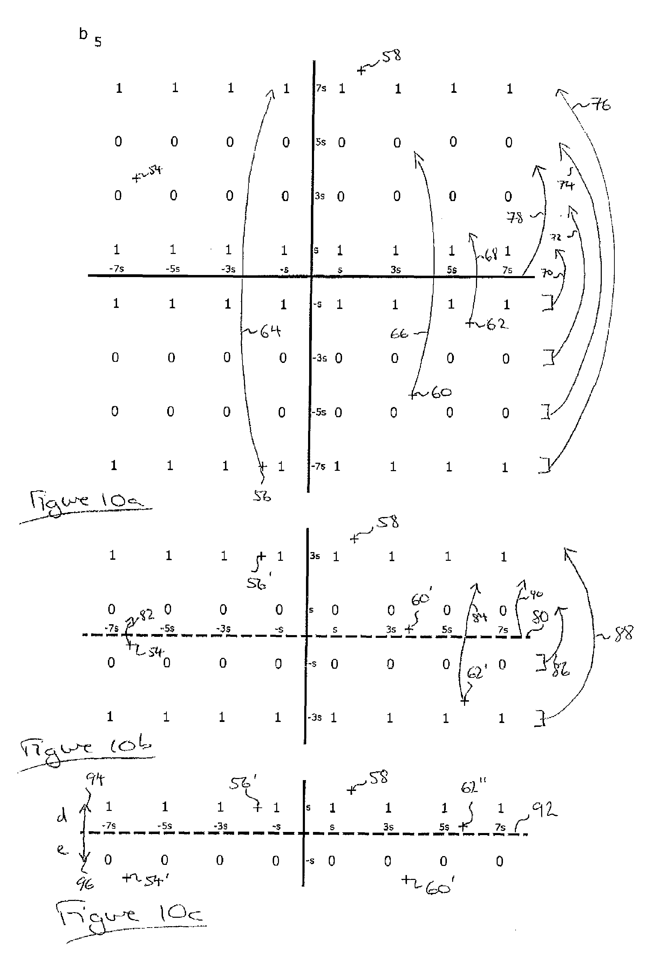

A method according to one embodiment of the invention when applied to a 64-QAM signal will now be described with reference to Figures 10a-10c, 11a-11c and 12a-12b.

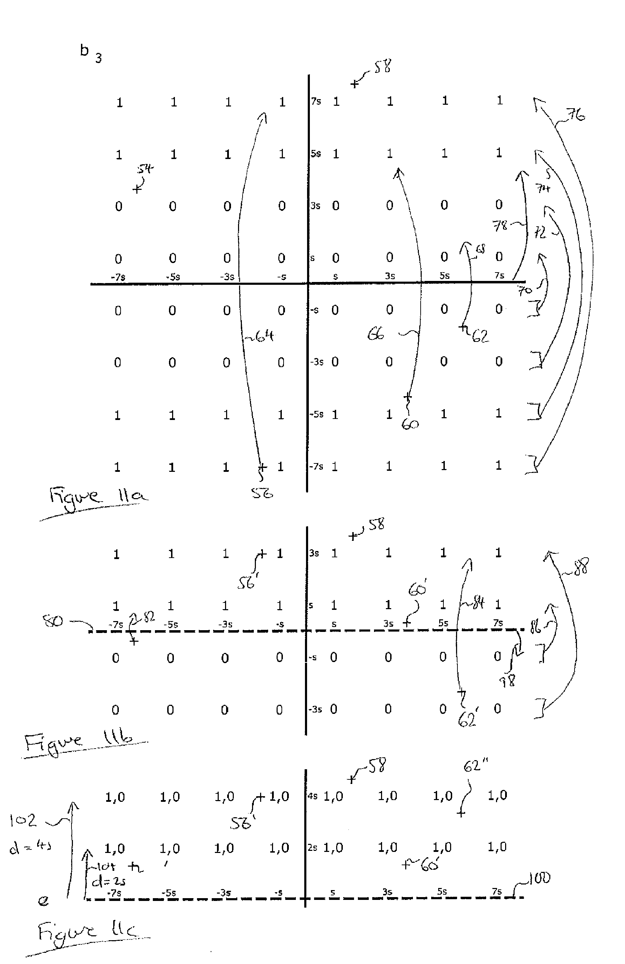

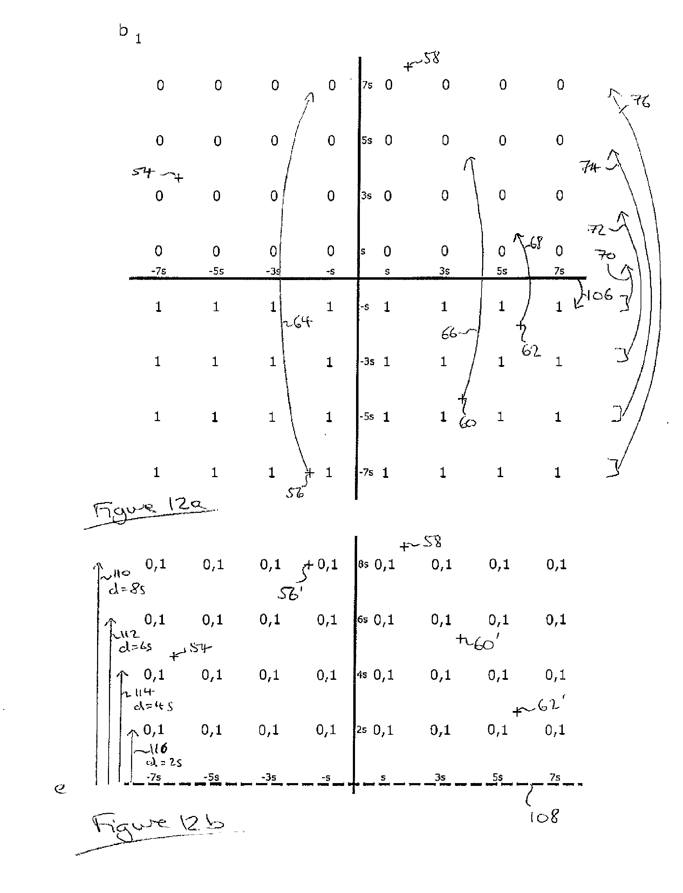

These figures are analogous to Figures 7a-7b and 8a-8b in that the values corresponding to one bit of the constellation points are shown. Figures 10a-10c show the values corresponding to the fifth bit, $b_5$, i.e. the value of $p_5$. Figures 11a-11c show the values corresponding to the third bit, $b_3$, i.e. the value of $p_3$. Figures 12a-12b show the values corresponding to the first bit, $b_1$, i.e. the value of $p_1$.

The diagrams are again scaled by the factor *s*. However, in the case of 64-QAM the points are distributed such that $s = 1/\sqrt{42}$ provides unit power.

Received symbol values 54, 56, 58, 60 and 62 are shown on the constellation diagrams.

With reference to figures 10a-10c, a method according to one embodiment of the invention , for calculating the soft decision for $b_5$ will be described. It will be realized that this calculation shares many aspects with the calculation for the 16-QAM system.

At a first stage in this calculation the constellation diagram is simplified by folding the constellation diagram about the real axis. Again, this may be considered analogous to a mapping of all the points. Alongside this mapping and translation of constellation points the coordinates of any received symbol will also be mapped in to the top half of the constellation diagram. The constellation diagram is then translated by a distance of 4*s* in the negative direction parallel to the imaginary axis, an operation again analogous to a translation of the axis.

Arrows 64, 66 and 68 show the mapping of the received symbols 56, 60 and 62 respectively. Received symbols 56, 60 and 62 are mapped because they are in the lower half of the constellation diagram. Received symbols 54 and 58 are not mapped because they are in to the upper half of the constellation diagram.

The mapping of the received symbols also correspond to a mapping of the constellation points. Arrows 70, 72, 74 and 76 show the mapping of the constellation points from the lower half to the upper half.

Finally the constellation diagram is translated, this movement is represented by arrow 78 showing, for simplicity. an equal and opposite movement of the axis.

The resultant constellation diagram is shown in Figure 10b. In this figure, received symbol points 54 and 58 remain unchanged, however received symbol points 56', 60' and 62' represent the mapped or folded points 56, 60 and 62. The new real axis is represented by the dotted line 80.

The resulting constellation diagram is similar to that shown in Figure 7a, i.e, it is similar to the constellation diagram for 16-QAM. Consequently, the constellation diagram may be again folded in a similar manner to that described with reference to Figures 7a and 7b.

Therefore, the constellation diagram is folded or mapped again about the real axis. The points then being translated by a distance 2$s$ in the negative direction parallel to the imaginary axis

Arrows 82 and 84 show the mapping of the received symbols 54 and 62' respectively. Received symbols 54 and 62' are mapped because they are in the lower half of the constellation diagram. Received symbols 56', 58 and 60' are not mapped because they are in to the upper half of the constellation diagram.

The mapping of the received symbols also correspond to a mapping of the constellation points. Arrows 86 and 88 show the mapping of the constellation points from the lower half to the upper half.

Finally the constellation diagram is translated, this movement being represented by arrow 90.

The resultant constellation diagram is shown in Figure 10c. In this figure, received symbol points 56', 58 and 60' remain unchanged, however received symbol points 54' and 62" represent the mapped or folded points 54 and 62'. The new real axis is represented by the dotted line 92.

There will again be noted that, similar to Figure 7b, the closest constellation points for each received symbol are now located along lines of value $s$ and -$s$. Consequently the values for $d$ and $e$ are always going to be $s$ and -$s$. Lines 94 and 96 show lengths $d$ and $e$ respectively.

It can also be seen that the relative position of the received symbols relative to the constellation points is unchanged. Consequently, equation (11) may again be used to directly and exactly calculate the LLR and thus $b_5$ without any further manipulation.

Mathematically, the calculation of the LLR for $b_5$ may be represented by the following, where z is the received symbol. Set $s$ as the 1 over the square root of 42:

$$s = \frac{1}{\sqrt{42}} \qquad (23)$$

Define $y$ as the imaginary part of $z$:

$$y = \mathrm{Im}(z) \qquad (24)$$

Perform the first folding/mapping:

$$y' = |y| - 4s \qquad (25)$$

Perform the second folding/mapping:

$$y_5 = |y'| - 2s \qquad (26)$$

As described above, as a result of the mapping, $d = s$ and $e = $ -$s$, therefore substitute these values into the equation for the LLR:

$$LLR_5 = 2s(2y_5 - 0) \cdot \delta^{-2} \qquad\qquad (27)$$

Therefore b$_5$, representing the soft decision for the fifth bit of received symbol *z* is:

$$b_5 = LLR_5 = 4sy_5 \cdot \delta^{-2} \qquad\qquad (28)$$

With reference to Figures 11a-11c, a method for calculating the soft decision for b$_3$ will be described.
Figure 11a shows the constellation diagram showing the values of $p_3$ at each constellation point. This constellation diagram is mapped in the same way as the constellation diagram in Figure 10a was. Consequently the reference numerals are the same.
The resulting folded constellation diagram shares many aspects with the constellation diagram shown in Figure 8a. The method is therefore similar.
The constellation diagram in Figure 11b is folded a second time about the real axis in a similar fashion to the folding shown in Figure 10b. However, in this case, the constellation diagram is translated a distance s in the positive direction parallel to the imaginary axis. This movement in shown by arrow 98 marking the corresponding movement of the axis. Since the folding is otherwise the same, the other reference numerals are the same as shown in Figure 10b.
Figure 11c shows the constellation diagram after the two folding operations described above. In a similar manner to Figure 11c, the mapped received symbols are marked by reference numerals 54', 56', 58, 60' and 62". The real axis is shown marked with reference numeral 100.
As described above with reference to Figure 8b, for a received symbol in one half of the constellation diagram, one of the two nearest constellation points will be located in the other half of the diagram. Consequently, for the same reasons, the value for *e* is zero, irrespective of the position of the received symbol.
The value of *d* again depends on the position of the constellation point. It can be seen that the value for *d* will be either 4*s* (represented by line 102) or 2*s* (represented by line 104).
In an analogous manner to that described above with respect to the 16-QAM method, the selection of which value *d* will take can be made by looking at the sign of the previously calculated bit b$_5$, *d* may therefore be defined as:

$$d = (3 + \text{sgn}(b_5)) \qquad\qquad (29)$$

Mathematically, this calculation for b$_3$ may be represented by the following, where *z* is the received symbol.
Set *s* as the 1 over the square root of 42:

$$s = \frac{1}{\sqrt{42}} \qquad\qquad (23 \text{ repeated})$$

Define *y* as the imaginary part of *z*:

$$y = \text{Im}(z) \qquad\qquad (24 \text{ repeated})$$

Perform the first folding/mapping:

$$y' = |y| - 4s \qquad\qquad (25 \text{ repeated})$$

Perform the second folding/mapping:

$$y_3 = |y'| + 1s \tag{30}$$

Define $d$ and $e$:

$$d = (3 + \text{sgn}(b_5))s, e = 0 \tag{31}$$

Substitute these values into the equation for the LLR:

$$LLR_3 = -\text{sgn}(y')(d)(2y_3 - d) \tag{32}$$

Therefore $b_3$, representing the soft decision for the third bit of received symbol z is:

$$b_3 = LLR_3 = -\text{sgn}(y')(3 + \text{sgn}(b_5))s(2y_3 - (3 + \text{sgn}(b_5))s) \tag{33}$$

Finally, with reference to Figures 12a-12b, a method for calculating the soft decision for $b_1$ will be described.

Figure 12a shows the constellation diagram showing the values of $p_1$ at each constellation point. This constellation diagram is mapped in a similar way as the constellation diagrams in Figures 10a and 11a were. Consequently the reference numerals are the same. In this case, the constellation diagram is translated by a distance $s$ in the positive direction parallel to the imaginary axis. Arrow 106 shows this movement by representing the corresponding movement of the axis.

Figure 12b shows the resulting constellation diagram. The mapped received symbols are marked by reference numerals 56', 60' and 62'. The unmapped received symbols are shown by reference numerals 54 and 58. The real axis is shown marked with reference numeral 108.

Figure 12b is similar to that shown in Figures 8b and 11c. However it will be noted that there are four constellation points in the imaginary direction, whereas Figures 8b and 11c showed only 2 constellation points. However, for the same reasons as above, for a received symbol in one half of the constellation diagram, one of the two nearest constellation points will be located in the other half of the diagram. Consequently, the value for $e$ is zero, irrespective of the position of the received symbol.

The value of $d$ again depends on the position of the constellation point. However, in this case, the $d$ may take one of 4 values. $d$ may be $8s$, represented by line 110, $d$ may be $6s$, represented by line 112, $d$ may be $4s$, represented by line 114, or $d$ may be $2s$, represented by line 116.

The selection of which value $d$ will take can be made by looking at the sign of the previously calculated bits $b_5$ and $b_3$. By inspection of Figure 10a it can be seen that the sign of $b_5$ will be positive if the constellation point is nearest the lines at value $s$ and $7s$. Similarly by inspection of Figure 11a it can be seen that the sign of $b_3$ will be positive if the constellation point is nearest the lines at value $5s$ and $7s$. It can also be seen that the constellation points along the lines at $7s$, $5s$, $3s$ and $s$ in Figures 10a and 11a correspond to those along the lines at $8s$, $6s$, $4s$ and $2s$ in Figure 12b. A table summarizing this is shown below:

| sgn($b_5$) | sgn($b_3$) | $d$ |
|---|---|---|
| 1 | 1 | $8s$ |
| -1 | 1 | $6s$ |
| -1 | -1 | $4s$ |
| 1 | -1 | $2s$ |

Alternatively, $d$ may be defined mathematically as:

$$d = (3 + \text{sgn}(b_3)\text{sgn}(b_5) + 2(1 + \text{sgn}(b_3)))s \tag{34}$$

Mathematically, this calculation for $b_1$ may be represented by the following, were $z$ is the received symbol.

Set $s$ as the 1 over the square root of 42:

$$s = \frac{1}{\sqrt{42}} \qquad\qquad (23 \text{ repeated})$$

Define $y$ as the imaginary part of $z$:

$$y = \mathrm{Im}(z) \qquad\qquad (24 \text{ repeated})$$

Perform the folding/mapping:

$$y_1 = |y| + s \qquad\qquad (35)$$

Define $d$ and $e$:

$$d = \left(3 + \mathrm{sgn}(b_3)\,\mathrm{sgn}(b_5) + 2(1 + \mathrm{sgn}(b_3))\right)s, e = 0 \qquad\qquad (36)$$

Substitute these values into the equation for the LLR:

$$LLR_1 = -\mathrm{sgn}(y)(d)(2y_1 - d) \qquad\qquad (37)$$

Therefore $b_3$, representing the soft decision for the third bit of received symbol z is:

$$b_1 = LLR_1 = -\mathrm{sgn}(y)\left(3 + \mathrm{sgn}(b_3)\,\mathrm{sgn}(b_5) + 2(1 + \mathrm{sgn}(b_3))\right)s \cdot$$
$$\left(2y_1 - \left(3 + \mathrm{sgn}(b_3)\,\mathrm{sgn}(b_5) + 2(1 + \mathrm{sgn}(b_3))\right)s\right) \qquad (38)$$

The calculations for bits $b_4$, $b_2$ and $b_0$ may be derived by analogy in a similar manner performed in the calculation for 16-QAM.

A further embodiment of the invention will now be described with reference to Figure 13. This Figure shows a generalized method for determining a soft decision for a received symbol.

With reference to embodiments of the invention described above, it can be seen that the decisions made for some bits are used in the decisions for other bits. For example, the LLR decision for bit $b_1$ in the 64-QAM method was derived using the signs of bits $b_3$ and $b_5$. Consequently it is of benefit, although not essential, to establish an order for calculating the LLR for each bit.

The bits associated with a received symbol may be provided with an arbitrary indicator. In the following method the indicators are defined from zero to the number of bits subtract one. In other words, for a 64-QAM signal, the bits have indicators 0 to 5, as used above. In the following method, the numerical order in which the LLR is calculated is from the highest numbered bit down to the zero numbered bit.

The bits which should be calculated first are the ones for which there will be the greatest number symmetrical folds. A symmetrical fold in this case is one where each constellation point is mapped onto a constellation point of the same value. An inversely symmetrical fold is where each constellation point is mapped onto a constellation point of the opposite value.

To provide an example, in the method for 64-QAM described above, bit $b_5$ involved 2 symmetrical folds and was therefore calculated first. Bit $b_3$ had one symmetrical fold and one inversely symmetrical fold, and was performed second. Bit $b_1$ had only an inversely symmetrical fold, and was performed last.

An alternative way of looking at this is to perform the calculation first for the bits with the lowest grouping of constellation points having the same value. In other words, again with reference to the 64-QAM method described above, the values corresponding to bit $b_5$ were grouped in a vertical direction such that there were 7 groups of values. The values corresponding to bit $b_3$ were grouped such that there were only three groups. Finally the values corresponding to bit $b_1$ were grouped into only two groups, one on either side of the axis.

Since the calculations for the real and imaginary parts are separate, the calculations may also be performed separately. In other words, the bits corresponding to the imaginary values may be calculated before, after, interleaved with or separately from the bits corresponding to real values. In the 64-QAM example above, the odd numbered bits are associated with the imaginary values and the even numbered bits (including zero) are associated with the real values.

As described above, this method of mapping and translation to simplify the operation of calculation may be used in 16-QAM and 64-QAM. We shall now describe a method whereby it is possible to expand on these examples to produce a more generally applicable method.

The general method shown in Figure 13 will now be described in more detail. Reference will also be made to Figure 14 which shows an electronic device in which an embodiment of the invention may be realized.

Figure 14 shows a detailed schematic view of part of the electronic device shown in Figure 3. Processor 913 may comprise a data receiver 118 which receives the received signal on connection 120. This received signal may be provided by the interface unit 917 shown in Figure 3. The receiver 118 may be connected to a controller 122 by connection 124.

Controller 122 may be connected to a memory 126 via connection 128. The controller 122 may also be connected to memory 914 via connection 130. Memory 914, as shown in Figure 3 is external to the processor 913.

Controller 122 may also be connected to a mapping module 132 via connection 134. Controller may also be connected to a translating module 136 via connection 138. Translating module 136 may also be connected to mapping module 132 via connection 140.

The controller 122 may also be connected to calculating module 142 via connection 144. Finally controller 122 may be connected to output module 146 via connection 148. Output module 142 may be connected to other circuitry in the electronic device.

While the above modules have been described as being contained within processor 913, some of the modules may be located in separate hardware, either in dedicated hardware 919 as shown in Figure 3, or in a separate processor. Furthermore one or more of these modules may be implemented as software operated on processor 913.

In operation, a signal may be received by the electronic device and passed to the processor. This signal may contain training data and header data. The training data corresponds to known data, which may be stored in memory 914. The received training data is compared with the known data to determine the characteristics of the channel by which the signal is being transmitted. In other words, the training data enables the electronic device to determine parameters for equalizing and scaling the received signal.

The header data may indicate the encoding system, such as 16-QAM, or 64-QAM which is to be used. Alternatively this encoding system may be predefined in the system.

The training and/or header data may be received before during or after the payload data is received. The payload data may be temporarily stored in a memory 914

With reference to the method shown in Figure 13 a method according to the invention will be described in more detail.

In step S1 the symbol (of value $z$) is received. This may be at receiver 118. The received symbol may have already been manuipulated (for example by equalizing or scaling the symbol), or may be manipulated by receiver 118. Alternatively or additionally the received symbol may be manipulated by a further module. The received symbol is passed to controller 122.

In step S2 controller 122 sets a counter I to one less than the number of bits used in the encoding method. In other words, for 64-QAM, I would be set to 6 - 1 = 5. This may be done by analyzing the received symbol, or by prior knowledge of the encoding method used.

In step S3 the controller selects the I$^{th}$ bit for the calculation. In step S4 the controller selects appropriate axis and direction. The selected axis will the axis parallel to the direction in which the constellation points have repeated values for the I$^{th}$ bit. To put this another way, the axis is defined such that the selected bit for each constellation point along a line parallel to the axes has the same value. The axis passes through the origin, i.e. the centre of the constellation diagram. With reference to Figure 10a, the selected axis for bit $b_5$ is the real axis. The selected direction is perpendicular to the selected axis.

In step S5 the controller selects the real or imaginary part of z. The choice is made in dependence on the selected direction. In other words, if the selected direction is the imaginary direction, the imaginary part of z will be selected.

In step S6 the binary values of the I$^{th}$ bit of each constellation point are calculated. This may be done by controller 122. Alternatively or additionally, the binary values may be stored in for example memory 914.

In decision block S7, the controller determines the symmetry of the constellation diagram corresponding to the selected bit. As described above, a symmetric constellation diagram is one which each constellation point is mirrored through the selected axis by a constellation point having the same value. An inversely symmetric constellation diagram has each constellation point mirrored through the selected axis by a constellation point having the opposite value. The symmetry of the constellation diagram may be calculated in the controller, alternatively or additionally the symmetry may have been previously stored.

If the constellation diagram is symmetric, then, in step S8 it is folded about the selected axis. This folding may be viewed as a reflection through the selected axis of all point on one side of the axis to the other side of the axis Alternatively, the folding may be visualized as a mapping of all points on one side of the selected axis to corresponding points on the other side of the selected axis. The mapping being done based on the absolute value of coordinate of the point in the selected direction. This mapping is a mapping of both the constellation points and the received symbol.

This mapping operation may be performed by the controller passing the value determined in step S5 to mapping module 132. In addition to the value determined in step S5, the controller may pass control parameters to the mapping module. These control parameters may include information on the encoding system used for the symbol.

Next, in step S9 the constellation diagram is translated so that the centre of the constellation diagram is located at the zero point of the axes. In other words, there are an equal number of constellation points on each side of the axes. As described above, this may be considered as a movement of the axes relative to the constellation diagram. This translation may be performed by providing the mapped value from module 132 to translating module 136. The translating module performing a translating operation on the value provided. The translating module my also receive control parameters from controller 122 via connection 138. The translating module may provide the translated value to controller 122 via connection 138.

The process returns to decision block S7 after step S9. Steps S8 and S9 may be repeated multiple times depending on the coding method and the selected ($I^{th}$) bit. For example, Figures 10a to 10c show two such foldings. In each case the controller module may provide the symbol and any control parameters (if applicable) to the modules 132 and 136 to be mapped and translated.

If in step S7, the controller determines that the constellation diagram is inversely symmetric, then the method proceeds to decision block S 10. In this decision block it is determined whether there are only two lines of constellation points remaining. In other words, this block determines if all of the constellation points of binary value 1 have been mapped onto a single set of points all sharing the same coordinate in the selected direction. Such a scenario will correspond to all points of binary value 0 being mapped onto a single set of points. Constellation diagrams with only two lines are shown in Figures 7b and 10c.

If it is determined that there are more than two lines, in step S11 the constellation diagram is folded about the selected axis in a similar manner to step S8. In step S12 the constellation diagram is translated such that there is a separation of $2s$ between the selected axis and the closest constellation points. This typically corresponds to a translation of the constellation points by a distance $s$ in the positive direction perpendicular to the selected axis.

Alternatively, this translation may be considered a translation of the selected axis such that it corresponds to the line of constellation points, closest to the axis, in the direction away from the resulting constellation points. In other words, the selected axis is moved in the negative direction by a distance $s$, where $s$ corresponds to half the distance between constellation points and the constellation points have been mapped in step S11 from the negative half of the constellation diagram to the positive half.

This mapping and translation may again be performed by the controller passing data to mapping module 132 and translating module 136. Since the translating operation is different in step S12 compared to step S9, the parameters provided by the controller module 122 to translating module 132 may be different.

In step S13 the values for $d$ and $e$ are defined. The value for $e$ will be zero, corresponding to the new position of the axis. The value of $d$ will depend on the sign of previously calculated bits. The value of $d$ may be calculated by a number of methods. However for any encoding method, a table (such as the one above) may be constructed showing the correlation between the value for $d$ and the signs of the previously determined bits. This table may be used as a look up table, alternatively a formula, such as equation (33), may be constructed to reflect the table. Other method of deriving a value for $d$ will be apparent to the person skilled in the art and within the scope of the present invention. This defining step may be performed by the controller 122. The table may be derived by the controller 122 or stored in for example memory 914. The soft decisions for previously calculated bits may be stored in memory 126 and retrieved by controller 122.

The method proceeds from step S 13 to step S 15.

If the determination in step S10 is that there are only two lines, then in step S 14 the values for $d$ and $e$ are defined as $d = +s$ and $e = -s$. $s$ being half the distance between adjacent constellation points. Again, this may be done by the controller 122. The method then proceeds to step S 15.

In step S15 the LLR for the selected bit is calculated using equation (11) and the value of $d$ and $e$. This may be done by calculating module 142. Calculating module 142 may be sent the mapped and translated data and the values of *d* and *e*. Calculating module 142 may provide the calculated LLR value to controller 122. The calculated LLR value may be stored in memory 126 as it may be required in later calculations.

In step S16 the controller then determines if I = 0, in other words, whether the LLR has been calculated for all the bits. If the determination is positive, the method ends. If the determination is negative (i.e. the LLR has not been calculated for all bits of the received symbol) I is decreased by 1 in step S17 and the method returns to step S3 and is repeated for the remaining bits.

When the LLR has been calculated for all of the bits, the soft decisions for all of the bits may be provided to output module 146 or stored in memory 914.

While the invention has been described with reference to particular embodiments, it will be apparent that there is substantial leeway available to the skilled person in implementing the invention. In particular, while the folding/mapping has been combined with a translation of the constellation diagram, it will be apparent that this translation may be omitted and an appropriate scaling of the values for *d* and *e* will have the same effect. For example, the folding/mapping shown in Figure 7a may comprise only the mapping of the points and no translation. In this case, the appropriate values for *d* and *e* would be 3*s* and *s* respectively.

Similarly, while the above method has been conceptualized with reference to folding of constellation diagrams, it will be apparent that a computer program or dedicated hardware designed to perform the method will not, for example, be required to perform a mapping of the constellation points. Instead, the only requirement is to calculate appropriate values based on the received symbol and the encoding method used.

Moreover, parts of the method described above may be calculated prior to a signal being received, and stored in a memory. The stored data may then be used for the calculation. For example, it is known that for bit $b_5$ in a 64-QAM method as described above, there are two symmetrical foldings. Consequently, a stored algorithm may not need to determine if the constellation points are symmetric, but only used a stored algorithm which is pre-programmed to perform two symmetrical foldings.

It is within the scope of the invention to provide lookup tables to replace any or even all of the calculation steps. For example, the determination of *d* for certain bits may be performed by looking up an appropriate value in a table similar to the one above.

In general, the various embodiments of the invention may be implemented in hardware or special purpose circuits, software, logic or any combination thereof. For example, some aspects may be implemented in hardware, while other aspects may be implemented in firmware or software which may be executed by a controller, microprocessor or other computing device, although the invention is not limited thereto. While various aspects of the invention may be illustrated and described as block diagrams, flow charts, or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

For example the embodiments of the invention may be implemented as a chipset, in other words a series of integrated circuits communicating among each other. The chipset may comprise microprocessors arranged to run code, application specific integrated circuits (ASICs), or programmable digital signal processors for performing the operations described above.

The embodiments of this invention may be implemented by computer software executable by a data processor of the mobile device, such as in the processor entity, or by hardware, or by a combination of software and hardware. Further in this regard it should be noted that any blocks of the logic flow as in the Figures may represent program steps, or interconnected logic circuits, blocks and functions, or a combination of program steps and logic circuits, blocks and functions.

The memory may be of any type suitable to the local technical environment and may be implemented using any suitable data storage technology, such as semiconductor based memory devices, magnetic memory devices and systems, optical memory devices and systems, fixed memory and removable memory. The data processors may be of any type suitable to the local technical environment, and may include one or more of general purpose computers, special purpose computers, microprocessors, digital signal processors (DSPs) and processors based on multi core processor architecture, as non limiting examples.

Embodiments of the inventions may be practiced in various components such as integrated circuit modules. The design of integrated circuits is by and large a highly automated process. Complex and powerful software tools are available for converting a logic level design into a semiconductor circuit design ready to be etched and formed on a semiconductor substrate.

Programs exist to automatically route conductors and locate components on a semiconductor chip using well established rules of design as well as libraries of pre stored design modules. Once the design for a semiconductor circuit has been completed, the resultant design, in a standardized electronic format (e.g., Opus, GDSII, or the like) may be transmitted to a semiconductor fabrication facility or "fab" for fabrication.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention as defined in the appended claims.

**Claims**

1. An apparatus comprising; a determiner configured to determine a first value associated with a received signal; a processor configured to calculate an exact Max-Log maximum a priori decision for the received signal using the first value.

2. An apparatus comprising; a determiner configured to determine a first value associated with a received signal; a mapper configured to map the first value onto a second value; a processor configured to calculate a soft decision for the received signal using the second value.

3. The apparatus of claim 2 wherein the soft decision comprises at least one of:

    an indicator of a probability that the received signal corresponds to one or more of a plurality of known signals; and
    an indicator of a most probable one of the plurality of known signals.

4. The apparatus of claim 2 or claim 3 wherein each of the plurality of known signals is represented by a plurality of bits, the apparatus further comprising a selector configured to select a one of the plurality of bits, wherein the processor is configured to calculate a soft decision for a selected one of the plurality of bits.

5. The apparatus of claim 4 wherein the determiner is configured to determine the first value based on an identity of the selected bit.

6. The apparatus of any of claims 4 or claim 5 wherein the mapper is configured such that each possible value of the second value corresponds to two or more possible values of the first value.

7. The apparatus of claim 6 wherein the mapper is configured to perform one or more repeats of: calculating an absolute value of the first value and adding an offset to the calculated absolute value.

8. The apparatus of claim 7 wherein the number of repeats is selected based on the selected bit.

9. The apparatus of claim 7 or claim 8 wherein the offset is selected based on the selected bit and the number of repeats which have been made.

10. The apparatus of any of claims 4 to 9 wherein the processor is configured to calculate the soft decision by solving the equation $b_i = (d-e)(2y-(d+e)) \cdot \delta^{-2}$ where $b_i$ represents the soft decision for the selected bit, y represents the second value, $\delta^{-2}$ represents a function of noise and $d$ and $e$ represent values dependent on one or both of: the selected bit; and a soft decision of a bit other that the selected bit.

11. The apparatus of any of claims 7 to 10 wherein the plurality of known signals correspond to points on a constellation diagram, the constellation diagram comprising an axis for each selected bit, wherein the axis is defined such that the axis passes through the centre of the constellation diagram, and the selected bit for each constellation point along a line parallel to the axes has the same value.

12. The apparatus of claim 11 wherein the constellation diagram has a symmetry for a selected bit, the symmetry being determined by comparing a value of the selected bit for two or more constellation points aligned in a direction perpendicular to the axis

13. The apparatus of claim 12 wherein at least one of:

    the offset;
    the number of repeats;
    $d$; and

*e* are determined based on the symmetry of the constellation diagram for the selected bit.

**14.** The apparatus of any of claims 4 to 13 wherein the received signal is represented by a complex number which may be represented on a constellation diagram, the constellation diagram comprising a plurality of points corresponding to a plurality of known signals, wherein the soft decision is based on the difference in Euclidian distance between the received signal when represented on the constellation diagram and a first and a second point on the constellation diagram, wherein the first point is the closest one of all of the points for which the selected bit has a value of 1 and the second point is the closest one of all of the points for which the selected bit has a value of 0.

**15.** An apparatus comprising; means for determining a first value associated with a received signal; means for mapping the first value onto a second value; means for calculating a soft decision for the received signal using the second value.

**16.** A computer program product comprising a method comprising; determining a first value associated with a received signal; mapping the first value onto a second value; calculating a soft decision for the received signal using the second value.

**17.** A method comprising; determining a first value associated with a received signal; mapping the first value onto a second value; calculating a soft decision for the received signal using the second value.

Figure 1

Figure 2

Figure 3

Figure 4

Figure 5

Figure 6

Figure 7a

Figure 7b

31

Figure 8a

Figure 8b

|        |        |        |        |     |        |        |        |        |
|--------|--------|--------|--------|-----|--------|--------|--------|--------|
| 101111 | 101101 | 100101 | 100111 |     | 000111 | 000101 | 001101 | 001111 |
| +      | +      | +      | +      | 7s  | +      | +      | +      | +      |
| 101110 | 101100 | 100100 | 100110 |     | 000110 | 000100 | 001100 | 001110 |
| +      | +      | +      | +      | 5s  | +      | +      | +      | +      |
| 101010 | 101000 | 100000 | 100010 |     | 000010 | 000000 | 001000 | 001010 |
| +      | +      | +      | +      | 3s  | +      | +      | +      | +      |
| 101011 | 101001 | 100001 | 100011 |     | 000011 | 000001 | 001001 | 001011 |
| +      | +      | +      | +      | s   | +      | +      | +      | +      |
| -7s    | -5s    | -3s    | -s     |     | s      | 3s     | 5s     | 7s     |
| 111011 | 111001 | 110001 | 110011 |     | 010011 | 010001 | 011001 | 011011 |
| +      | +      | +      | +      | -s  | +      | +      | +      | +      |
| 111010 | 111000 | 110000 | 110010 |     | 010010 | 010000 | 011000 | 011010 |
| +      | +      | +      | +      | -3s | +      | +      | +      | +      |
| 111110 | 111100 | 110100 | 110110 |     | 010110 | 010100 | 011100 | 011110 |
| +      | +      | +      | +      | -5s | +      | +      | +      | +      |
| 111111 | 111101 | 110101 | 110111 |     | 010111 | 010101 | 011101 | 011111 |
| +      | +      | +      | +      | -7s | +      | +      | +      | +      |

Figure 9

33

b $_5$

Figure 10a

Figure 10b

Figure 10c

b$_3$

58

| 1 | 1 | 1 | 1 | 7s 1 | 1 | 1 | 1 |
|---|---|---|---|---|---|---|---|
| 1 | 1 | 1 | 1 | 5s 1 | 1 | 1 | 1 |
| 0 | 0 | 0 | 0 | 3s 0 | 0 | 0 | 0 |
| 0 | 0 | 0 | 0 | s 0 | 0 | 0 | 0 |
| -7s | -5s | -3s | -s | s | 3s | 5s | 7s |
| 0 | 0 | 0 | 0 | -s 0 | 0 | 0 | 0 |
| 0 | 0 | 0 | 0 | -3s 0 | 0 | 0 | 0 |
| 1 | 1 | 1 | 1 | -5s 1 | 1 | 1 | 1 |
| 1 | 1 | 1 | 1 | -7s 1 | 1 | 1 | 1 |

54  64  66  62  68  70  72  74  76  78  56  60

Figure 11a

58

| 1 | 1 | 1 | 1 | 3s 1 | 1 | 1 | 1 |
|---|---|---|---|---|---|---|---|
| 1 | 1 | 1 | 1 | s 1 | 1 | 1 | 1 |
| -7s | -5s | -3s | -s | s | 3s | 5s | 7s |
| 0 | 0 | 0 | 0 | -s 0 | 0 | 0 | 0 |
| 0 | 0 | 0 | 0 | -3s 0 | 0 | 0 | 0 |

80  82  56'  60'  84  86  88  78  62'

Figure 11b

58  62"

| 1,0 | 1,0 | 1,0 | 1,0 | 4s 1,0 | 1,0 | 1,0 | 1,0 |
|---|---|---|---|---|---|---|---|
| 1,0 | 1,0 | 1,0 | 1,0 | 2s 1,0 | 1,0 | 1,0 | 1,0 |
| -7s | -5s | -3s | -s | s | 3s | 5s | 7s |

102  d = 4s  104  d = 2s  e  56'  60'  100

Figure 11c

b₁

```
                              ╭∽58
      0      0      0      0  │7s  0      0      0      0              ╭∽76
                             ┊                                       ↗
                                                                74↗
      0      0      0      0  │5s  0      0      0      0
54 ╶╮+                                                          72↗
      0      0      0│     0  │3s  0      0      0      0       70↗
                                                       ╭68
      0      0      0│     0  │s   0      0      0 ╭68  0      ╰106
    ─7s    ─5s    ─3s    ─s ─┼─ s     3s     5s     7s ──────────
      1      1      1│     1  │─s  1      1      1      1↗╰106
                    ∽64                       66∽
      1      1      1│     1  │─3s 1      1      1      1
                                                    62
      1      1      1│     1  │─5s 1      1 ╮60  1      1
      1      1      1  +  1  │─7s 1      1      1      1
                    56
```

Figure 12a

```
  ↑∽110  0,1    0,1    0,1  +0,1 │8s 0,1    0,1    0,1    0,1
  │ d=8s                    56'
  │
  ↑∽112  0,1    0,1    0,1    0,1│6s 0,1    0,1    0,1    0,1
  │ d=6s        +∽54                            +∽60'
  │
  ↑  0,1  0,1    0,1    0,1    0,1│4s 0,1    0,1    0,1    0,1
  │∽114                                              +∽62'
  │ d=4s
  ↑ 0,1   0,1    0,1    0,1    0,1│2s 0,1    0,1    0,1    0,1
   ∽116
   d=2s
    ─7s   ─5s    ─3s    ─s ─┼─ s     3s     5s     7s ─ ─ ─
e                                                     ╰108
```

Figure 12b

Figure 13

**Start**

Receive Symbol (z) — S1

Set counter I = number of bits – 1 — S2

Select I$^{th}$ bit — S3

Select direction/axis — S4

Calculate Re(z) or Im(z) — S5

Determine constellation point values — S6

Determine symmetry — S7

Symmetric → Fold constellation diagram about selected axis — S8

S9 → Translate constellation diagram so zero point is at centre

Inversely symmetric

2 lines of constellation points? — S10

No → Fold constellation diagram about selected axis — S11

Translate constellation diagram by s — S12

Define values for d and e where e = 0 and d = f(b$_n$) — S13

Yes → Define values for d and e where d = +s and e = –s — S14

Calculate LLR for selected bit — S15

I = 0? — S16

Yes → End

No → Decrease I by 1 — S17

Figure 14